# EUROPEAN PATENT APPLICATION

(11) **EP 4 700 472 A1**
(43) Date of publication of application: **25.02.2026**
(21) Application number: 24195303.3
(22) Date of filing: 20.08.2024
(51) Int. Cl.: G03F 7/00

(54) **IMPROVED DOSE CONTROL IN A LITHOGRAPHIC APPARATUS**

(71) Applicant: ASML Netherlands B.V., 5500 AH Veldhoven (NL)
(72) Inventor: HARTGERS, Albertus, 5500 AH Veldhoven (NL); STEEGHS, Marco, Matheus, Louis, 5500 AH Veldhoven (NL); VAN SLUISVELD, Wouterus, Jozephus, Johannes, 5500 AH Veldhoven (NL); STOFFELS, Freerk, Adriaan, 5500 AH Veldhoven (NL); GOUDZWAARD, Maurits, 5500 AH Veldhoven (NL); SZWEDOWICZ, Konrad, 5500 AH Veldhoven (NL)
(74) Representative: ASML Netherlands B.V.

(57) **Abstract**

A dose control system to control a dose of a radiation beam comprises an energy sensor comprising a first sensor area to measure an intensity of the radiation beam, and at least one second sensor area to measure an impact of misalignment or clipping of the radiation beam on the intensity of the radiation beam. The dose control system further comprises a control device to determine a difference between the measured intensity of the radiation beam and the measured impact of misalignment or clipping of the radiation beam on the intensity of the radiation beam, and control a dose of the radiation beam on the basis of the determined difference.

## Description

### FIELD

The present invention relates to a dose control system configured to control a dose of a radiation beam in a lithographic apparatus and to an illuminator comprising such a dose control system. Further, the invention relates to a lithographic apparatus comprising such a dose control system or illuminator and to a method of controlling a dose of a radiation beam. Still further, the invention relates to a method of generating radiation, a method of manufacturing a semiconductor device and a semiconductor device manufactured by the method.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask or reticle) onto a layer of radiation-sensitive material (resist) or photoresist provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm.

In an EUV lithographic apparatus, a radiation beam is projected on a substrate. An illuminator projects radiation generated by a source of radiation, such as a laser produced plasma source, onto a part of the reticle. This part of the reticle that receives radiation is also referred to as slit or reticle slit. The illuminator may comprise a plurality of mirrors configured to project the radiation generated by the source of radiation, onto the slit. A dose control system is configured to control an intensity or a dose of the radiation projected onto the slit. The dose control system may comprise a sensor configured to generate a measurement signal representative of the dose or intensity of the radiation. For example, an energy sensor may be arranged at a periphery of the slit. The measurement signal provided by the energy sensor may be used as feedback for a dose control loop.

The above dose control measurement may rely on the fact that a spot size of the radiation beam projected onto the slit is relatively large, enabling to measure an intensity or dose of the radiation beam at an edge of the spot of the radiation beam, e.g. at the periphery of the slit. New developments tend to make use of an illuminator mirror having a plurality of mirror segments. Using such a mirror having a plurality of mirror segments, a plurality of spots may be generated by the illuminator. However, a spot size per segment may be small. As a result, the measurement at the edge of the spot may not provide a measurement result representative of the dose or intensity.

### SUMMARY

It is desirable to provide dose measurement and dose control compatible with a small spot size of the radiation beam.

According to an aspect of the invention, there is provided a dose control system configured to control a dose of a radiation beam comprising
an energy sensor comprising
   - a first sensor area configured to measure an intensity of the radiation beam, and
   - at least one second sensor area configured to measure an impact of misalignment or clipping of the radiation beam on the intensity of the radiation beam, and
a control device configured to
   - determine a difference between the measured intensity of the radiation beam and the measured impact of misalignment or clipping of the radiation beam on the intensity of the radiation beam, and
   - control a dose of the radiation beam on the basis of the determined difference.

According to another aspect of the invention, there is provided an illuminator configured to condition a radiation beam, the illuminator comprising the dose control system according to the invention.

According to yet another aspect of the invention, there is provided a lithographic apparatus comprising the dose control system according to the invention or the illuminator according to the invention.

According to a further aspect of the invention, there is provided a method of controlling a dose of a radiation beam comprising
- measuring an intensity of the radiation beam, and
- measuring an impact of misalignment or clipping of the radiation beam on the intensity of the radiation beam,
- determining a difference between the measured intensity of the radiation beam and the measured impact of misalignment or clipping of the radiation beam on the intensity of the radiation beam, and
- controlling a dose of the radiation beam on the basis of the determined difference.

According to a further aspect of the invention, there is provided a method of generating radiation comprising
generating a plasma,
exciting the plasma to emit radiation, and
controlling a dose of the radiation by the method of controlling a dose according to the invention.

According to a further aspect of the invention, there is provided a method of manufacturing a semiconductor device comprising the steps of
receiving a substrate with a photoresist layer
directing radiation generated by the method of generating radiation according to the invention, to transfer a pattern from a patterning device onto the photoresist layer; and
removing a portion of the photoresist layer to form the pattern over the substrate.

According to a further aspect of the invention, there is provided a device manufactured according to the method of manufacturing a semiconductor device according to the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a highly schematic view of a part of an exposure apparatus according to an embodiment of the invention;
- Figure 3A - 3D depict highly schematic views of embodiments of an energy sensor as may be employed in embodiments of the present invention;
- Figure 4A - 4D depict highly schematic views of further embodiments of the energy sensor as may be employed in embodiments of the present invention.

### DETAILED DESCRIPTION

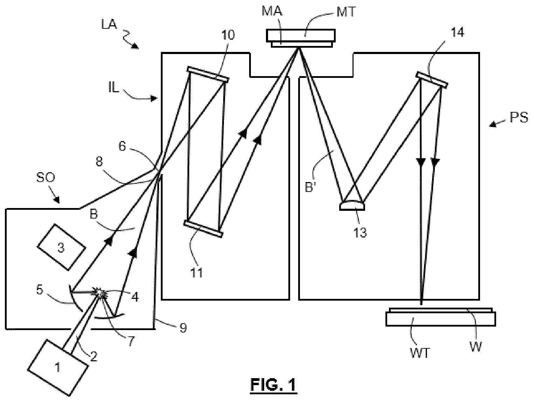

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask or reticle), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

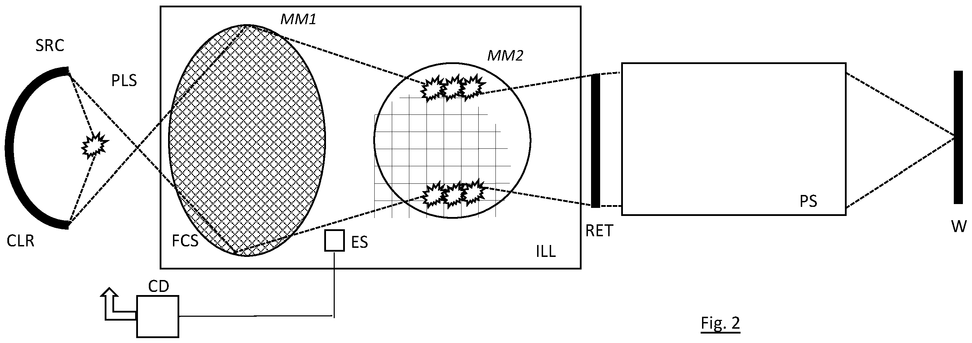

Figure 2 depicts a highly schematic view of a part of a lithographic apparatus in which the invention may be employed. The lithographic apparatus comprises a radiation source SRC which is configured to generate a plasma PLS that emits EUV radiation. A collector CLR collects the emitted EUV radiation and projects the collected EUV radiation on a first mirror MM1 of illuminator ILL. According to the present embodiment the first mirror MR1 comprises a plurality of facets FCS, such as ten-thousands, hundred-thousands or more facets. The facets are configured to image the plasma on respective parts of a second mirror MM2 of the illuminator of the lithographic apparatus. As depicted in Figure 2, the plasma is imaged on the second mirror MM2 with plural images adjacent to each other. For example, subsets of the facets may be configured to project overlapping images of the plasma on the second mirror MM2. From the second mirror MM2, the radiation beam is projected onto a slit, such as a reticle slit RET, and via a projection system PS, such as described with reference to Figure 1, on a substrate W.

As explained above, a dose control system may be employed which is configured to control an intensity or a dose of the radiation projected onto the reticle slit. The dose control system may comprise a sensor configured to generate a measurement signal representative of the dose or intensity of the radiation. For example, the energy sensor may be arranged at a periphery of the reticle slit. The measurement signal provided by the energy sensor may be used as feedback for a dose control loop. The dose control loop may for example affect a generation of the plasma, a laser excitation of the plasma, and//or an alignment of the mirrors, to thereby control an effective dose of the radiation beam projected onto the slit.

In EUV illuminators, the dose control measurement may rely on the fact that a spot size of the radiation beam projected onto the slit is relatively large, enabling to measure an intensity or dose of the radiation beam at an edge of the spot of the radiation beam, e.g. at the periphery of the slit.

EUV illuminators may comprise a mirror-module with adjustable field facets and a mirror-module with fixed pupil facets. Each field facet projects a plasma image onto an unique pupil facet, while at the same time, the pupil facet images the field facet onto the reticle slit. In most cases, the image of such a field facet also overlaps with one or two of the energy sensors.

Mechanisms that cause variation of the EUV light going towards the reticle slit may comprise:
- Plasma intensity fluctuations in the source,
- Variable clipping at the source aperture due to alignment variations (drift) in the source, and/or
- Variable clipping at the pupil facets due to alignment variations in the source and variations (drift) in field facet tilt.

Because of the position of the energy sensors adjacent to the reticle slit, and because they receive light from most of the field facets, the energy sensors are able to detect the impact of all of the above mechanisms, so that the dose energy control loop can compensate.

However, the larger the number of mirror segments of the projection mirror, the smaller a spot size projected by the mirror segments onto the slit may be. As a result, the previously proposed measurement at the edge of the spot may not provide a measurement result representative of the dose or intensity.

Reverting to Figure 2, the figure further depicts a dose control system configured to control a dose of a radiation beam. The dose control system comprises an energy sensor ES and a control device CD. The energy sensor is configured to measure the radiation beam as explained in more detail below. The control device is connected to the energy sensor to receive a signal or data representing a measurement performed by the energy sensor. The control device is configured to output a control signal to control a dose of the radiation beam. The energy sensor ES comprises a first sensor area configured to measure an intensity of the radiation beam, and at least one second sensor area configured to measure an impact of misalignment or clipping of the radiation beam on the intensity of the radiation beam.

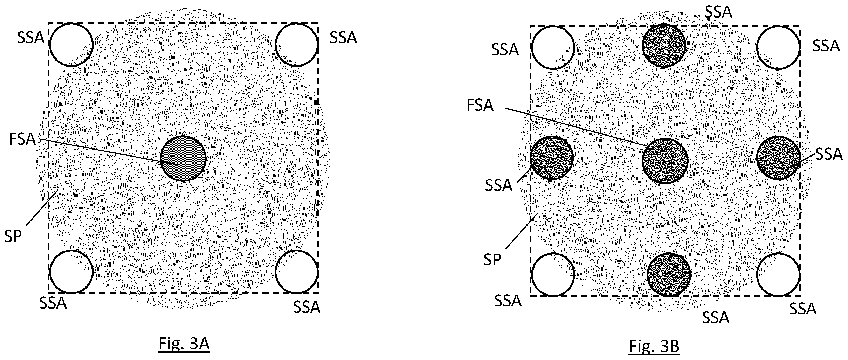

Figure 3A - 3D each depict an embodiment of the energy sensor. As depicted in Figure 3A, the energy sensor comprises a first sensor area FSA configured to measure an intensity of the radiation beam. In the present embodiment, the energy sensor further comprises four second sensor areas SSA configured to measure an impact of misalignment or clipping of the radiation beam. In the present embodiment, the four second sensor areas SSA are arranged around the first sensor area at an edge of a spot SP of the beam incident on the energy sensor.

The dose control system is configured to control a dose in that the control device is configured to determine a difference between the measured intensity of the radiation beam as measured by the first sensor area FSA and the measured impact of misalignment or clipping of the radiation beam on the intensity of the radiation beam as measured by the second sensor area SSA. The control device is configured to output a dose control signal to control a dose of the radiation beam on the basis of the determined difference.

**A** (small) part of the radiation beam may be branched off to the energy sensor. In an embodiment, a subset of the plurality of mirror segments of the illuminator mirror MM1 may be configured to project onto the energy sensor.

According to the present invention, an intensity of the radiation beam may be derived from the radiation measured by the first sensor area FSA of the energy sensor. The radiation beam, or a part thereof such as a part branched off to the energy sensor, may be incident on the first sensor area. For example, the first sensor area may be arranged at a location where a center of the radiation beam, or a center of the part of the radiation beam branched off to the energy sensor, is incident. An impact of misalignment or clipping of the radiation beam on the intensity of the radiation beam may be derived from the radiation measured by the second sensor area SSA of the energy sensor. For example, the second sensor area may be arranged circumferentially around the first sensor area at a location where an edge of the radiation beam, or an edge of a part of the radiation beam branched off to the energy sensor, is incident.

An effective dose is thus determined from the measured intensity of the radiation beam minus losses that may occur at the edges due to clipping, misalignment, etc. Accordingly, a dose of the radiation beam may be determined taking account of both the intensity of the radiation beam as well as taking account of effects due to clipping and/or misalignment of the radiation beam.

In the embodiment depicted in Figure 3A, the misalignment or clipping of the radiation beam may be derived from the sensor signals of the second sensor area. An average intensity of the sensor signals of the second sensor area may be taken into account, and may provide an indication of spot size. A difference between the intensity measured by the sensor signals of the second sensor area and the first sensor area may be taken into account and may provide an indication of misalignment and/or clipping. For example, a clipping/misalignment information may be derived from a difference between the sensor signals of the first sensor area FSA and the second sensor area SSA. The sensor signal of the first sensor area FSA may primarily vary as a result of changes in overall intensity of the spot. An increase of the sensor signal of the second sensor area SSA relative to the sensor signal of the first sensor area FSA may indicate a shift (or enlargement) of the spot, which may lead to additional clipping of light at mirror facets, such as mirror facets of the second mirror.

Figure 3B depicts another embodiment of the energy sensor, comprising eight second sensor areas arranged circumferentially to be irradiated by the edge of the beam incident on the energy sensor. With the eight second sensor areas, a determination may be performed similar to the four second sensor areas according to the embodiment depicted in Figure 3A, whereby the increased number of second sensor areas may enable a more accurate determination of misalignment and/or clipping.

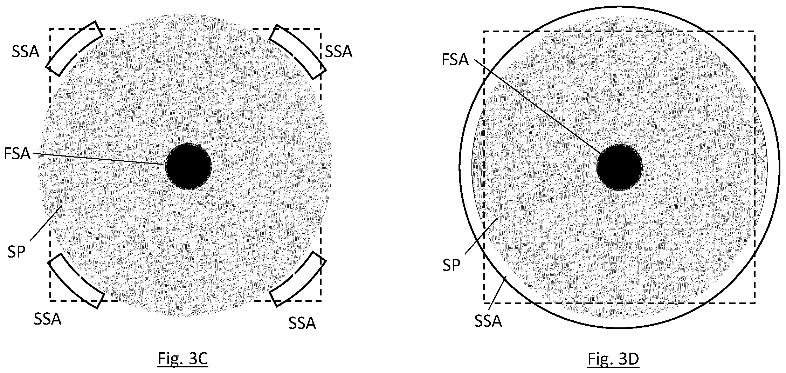

Figure 3C depicts a further embodiment of the energy sensor, again comprising a first sensor area at a center of the incident radiation beam or the part split off from the radiation beam, while segmented second sensor areas are arranged circumferentially around the first sensor area to detect an edge of the incident beam on the energy sensor. Due to the segmented outline of the second sensor areas, i.e. the outline of a segment of a circle around the first sensor area, a sensitivity for a displacement of the edge of the beam incident on the energy sensor is high.

Figure 3D depicts a further embodiment of the energy sensor, again comprising a first sensor area at a center of the incident radiation beam or the part split from the radiation beam, while a circular second sensor area is arranged circumferentially around the first sensor area to detect an edge of the incident beam on the energy sensor. Due to the circular outline of the second sensor area, being concentric with the first sensor area, a sensitivity for a displacement of the edge of the beam incident on the energy sensor is high. Similarly to Figure 3A, as a result of the intensity gradient at the edge of the spot, the sensor signal of the second sensor area SSA may increase in case the spot grows or shifts. For example, in case the spot shifts to the right, the intensity gradient causes a loss of signal (intensity) on the left to be less than a gain in signal on the right. Because the gradient at the first sensor area FSA is mostly flat, that signal may not, or far less, be affected by a spot shift.

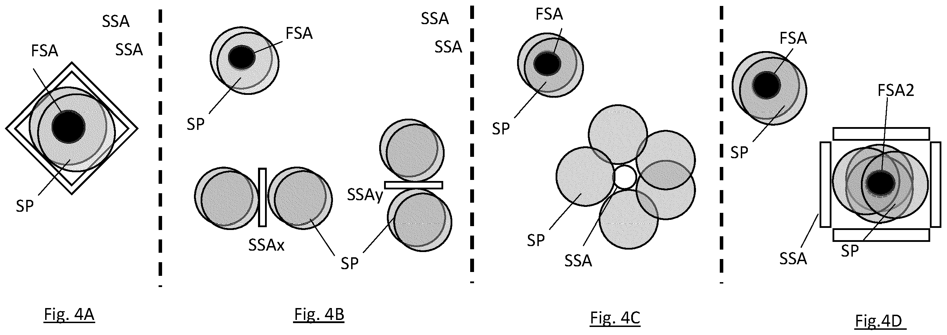

Figure 4A - 4D depict other embodiments of the energy sensor.

Figure 4A depicts a further embodiment of the energy sensor, again comprising a first sensor area at a center of the incident radiation beam or the part split from the radiation beam, while the second sensor area as squarely shaped, whereby the first sensor area is arranged at a center of the square formed by the second sensor area. In the example shown in Figure 4A, the 4 sides of the second sensor area form a single detector, however the second sensor area may alternatively be split in 4 separate area's whose signal may be averaged.

The embodiments depicted in Figures 4B - 4D comprise separate sensor areas to track radiation beam intensity and spot shift. In this way, an alignment of the spots towards the sensor areas may be used to mimic clipping at different mirror facets. Comparing the embodiments of Figures 3A - 3D and 4A with embodiments described above with reference to Figures 4B - 4D, an advantage of the former in respect to the latter may be that less radiation may be needed for the sensor areas, increasing radiation available for the slit, or that the averaging effect of multiple spots per sensor increases.

As remarked above, Figure 4A provides a layout similar to what is discussed above with reference to Figures 3A - 3D, however has an square second sensor area instead of the multiple points or segments to track spot shift (misalignment or clipping).

The embodiment as depicted in Figure 4B comprises multiple separate sensor areas to track intensity variation (the first sensor area), x-shift (the elongate second sensor area SSAx) and y-shift (the elongate second sensor area SSAy). Two spots of the radiation beam are projected at opposite elongate sides of the second sensor area for X shift, the edges of the spots touching, or the intensity gradients at the edge of the spots overlapping with, the elongate sides. Similarly, two spots of the radiation beam are projected at opposite elongate sides of the second sensor area for Y shift, the edges of the spots touching, or the intensity gradients at the edge of the spots overlapping with, the elongate sides. As the spots move in X direction respectively in Y direction, an intensity detected by the respective second sensor area changes.

The embodiment as depicted in Figure 4C depicts an energy sensor comprising first and second sensor areas and multiple separate spots of the radiation beam to track intensity variation (at the first sensor area) and shift (at the second sensor area). The first sensor area is arranged at a center of one of the spots. The second sensor area is arranged to detect a respective edge of plural spots projected around the second sensor area, whereby edges of the plural spots touch the second sensor area, or the intensity gradients at the edge of the spots overlap with the second sensor area. As the plural spots move in respect of the second sensor area, e.g. due to mis-alignment or clipping, a measurement value provided by the second sensor area may change, as the overlap with the spots may change.

The embodiment as depicted in Figure 4D depicts an energy sensor comprising a first sensor area FSA1. The first sensor area FSA1 is arranged at a center of one of the spots SP. In a preferred embodiment, the energy sensor comprises a further first sensor area FSA2 arranged at a center of another one of the spots SP, which may enable intensity tracking. Four second sensor areas are arranged to form a square (or circular or circle segment) shape, arranged around and at the circumferential edge of a respective spot of the radiation beam. The embodiment of the sensor according to Figure 4D may track intensity via the first sensor area and may track shift via the second sensors areas. Optionally, the further first sensor area FSA2 may be used for intensity tracking, in which case the first sensor area and its spot may be omitted.

An additional advantage of using separate sensor areas to measure intensity and spot misalignment may be that information on spot drift may become available for monitoring and/or correction of spot positions.

Further embodiments of the present development are presented below.

In an embodiment, as described above with reference to Figures 3A - 3D and 4A, the at least one second sensor area is arranged around the first sensor area. The first sensor area may be arranged at a center of the spot of the radiation beam while the at least one second sensor area may be arranged at the edge (e.g. the circumferential edge), enabling to detect both intensity and misalignment / clipping using a single spot.

For example, as illustrated amongst others in the embodiment according to Figure 3A - 3D, the at least one the second sensor area is circular around the first sensor area. A large sensitivity to a displacement of the spot of the radiation beam in respect of the second sensor area may be provided.

In an embodiment, the energy sensor comprises at least two second sensor areas, enabling to perform a differential measurement providing a high sensitivity to displacement of the spot of the radiation beam.

In an embodiment, the at least one second sensor area is offset in respect of the first sensor area. A first spot of the radiation beam may be provided to radiate on the first sensor area and a second spot of the radiation beam (the second spot offset in respect of the fist spot) may be provided to radiate on or at an edge of the second sensor area. Thus, the intensity of the radiation may be measured by the first sensor area, while an accurate measurement of mis-alignment and/or clipping may be derived from the measurement by the second sensor area. For the embodiments in accordance with Figures 4B and 4C, there may be a benefit in having smaller sensors (which may be easier to manufacture with good performance), at the cost of less light (signal) per sensor. In the embodiment in accordance with Figure 4D, a spot drift direction may be derived, if the segments (i.e. the 4 sides) of the second sensor area are sampled individually.

For example, in order to enable to accurately derive X and Y misalignment and/or clipping, as illustrated with reference to Figure 4B, for example, the at least two second sensor areas comprise a first pair of second sensor areas arranged to measure a deviation of the radiation beam in a first direction perpendicular to the radiation beam and a second pair of second sensor areas arranged to measure a deviation of the radiation beam in an second direction perpendicular to the radiation beam, the second direction being perpendicular to the first direction.

An accuracy of the dose control may be enhanced in that, in an embodiment, the control device is configured to, prior to determining the difference between the measured intensity of the radiation beam and the measured impact of misalignment or clipping of the radiation beam on the intensity of the radiation beam:
- multiply the measured intensity of the radiation beam by a first weight factor, and
- multiply the measured impact of misalignment or clipping of the radiation beam on the intensity of the radiation beam by a second weight factor. The weight factors may be pre-set of may be calibrated, such as by a one time calibration or a periodic calibration in operation, in that, in an embodiment, the control device is configured to calibrate the first weight factor and the second weight factor on the basis of a spatial energy distribution measurement of the radiation beam.

Calibration may be performed by scanning (from side to side) a calibration sensor on the substrate stage through an exposure slit. The calibration sensor may sample the dose on the substrate during the scan. At the same time, the signal on the first and second sensor areas of the energy sensor may be recorded. The first and second weight factors may be determined from the energy sensor signal and the actual dose on the substrate stage as measured by the calibration sensor.

According to another aspect of the invention, there is provided an illuminator configured to condition a radiation beam, the illuminator comprising the dose control system according to the invention.

In order to direct a spot of the radiation beam onto the energy sensor, in an embodiment, the illuminator comprises a first mirror comprising a plurality of facets, wherein a subset of the plurality of facets is configured to branch off a fraction of the radiation beam onto the energy sensor.

In an embodiment, in case the at least one second sensor area is arranged around the first sensor area, the subset of the plurality of facets is configured to project a center of the branched off fraction of the radiation beam onto the first sensor area and an edge of the branched off fraction of the radiation beam onto the at least one second sensor area. A single spot may thus be projected to be measured by the first sensor area as well as by the at least one second sensor area, providing a relatively high intensity at the single spot with a relatively low fraction of facets required to branch off.

In an embodiment, in case the at least one second sensor area is offset in respect of the first sensor area, two spots may be projected onto the energy sensor, in that the subset of the plurality of facets is configured to branch off the fraction of the radiation beam onto the first sensor area of the energy sensor and a further subset of the plurality of facets is configured to branch off further fraction of the radiation beam onto the second sensor area.

In an embodiment, the illuminator further comprises a second mirror, wherein the first mirror is configured to project the radiation beam onto the second mirror and wherein the subset of the plurality of facets is configured to branch of the fraction of the radiation beam before the second mirror. An accurate dose control may be performed, without a need to projected the branched of fraction via the second mirror. Placement of the energy sensor downstream of the second mirror may be avoided, which may be beneficial from a viewpoint of available space, maintenance and/or serviceability. An effect of the second mirror (e.g. misalignment, clipping) may for example be taken into account in the calibration factors described above.

According to yet another aspect of the invention, there is provided a lithographic apparatus comprising the dose control system as disclosed or the illuminator as disclosed.

According to yet another aspect of the invention, there is provided a method of controlling a dose of a radiation beam comprising
measuring an intensity of the radiation beam, and
measuring an impact of misalignment or clipping of the radiation beam on the intensity of the radiation beam,
determining a difference between the measured intensity of the radiation beam and the measured impact of misalignment or clipping of the radiation beam on the intensity of the radiation beam, and
controlling a dose of the radiation beam on the basis of the determined difference.

According to a further aspect of the invention, there is provided a method of generating radiation comprising generating a plasma, exciting the plasma to emit radiation, and controlling a dose of the radiation by the method of controlling a dose according to the invention.

According to a yet further aspect of the invention, there is provided a method of manufacturing a semiconductor device comprising the steps of
receiving a substrate with a photoresist layer
directing generated by the method of generating radiation according to the invention, to transfer a pattern from a patterning device onto the photoresist layer; and
removing a portion of the photoresist layer to form the pattern over the substrate.

According to a still further aspect of the invention, there is provided a device manufactured according to the method of manufacturing a semiconductor device according to the invention.

With the illuminator, the lithographic apparatus and the method according to the invention, the same advantages and effects may be achieved as described with reference to the dose control system according to the invention. Likewise, the same embodiments may be provided, exhibiting same or similar effects as described with reference to the dose control system according to the invention.

The present disclosure may provide an energy sensor before, or on, a second mirror of the illuminator, which may track intensity changes in a source of radiation because of plasma variation and clipping, and may track clipping at the second mirror facets because of alignment drifts. While the examples discussed here sometimes refer to images of a single mirror facet, a high number of facets may be projected overlapping onto the energy sensor (e.g. on the first sensor area, and/or at the edge of the second sensor area) to obtain a measurement signal that may be strong enough and may have sufficient averaging.

The present development may enable to track a signal representing the radiation source impact on slit intensity, and may track a signal representing the (mis)alignment impact on slit intensity. The second signal may be subtracted from the first to track the clipping e.g. at mirror facets of the second mirror. Together these signals may be used to provide accurate feedback in a dose control loop, and may allow for varying facet sizes of the second mirror. In this way, it may become possible to move the energy sensors before the second mirror, and support different second mirror facet sizes. An additional benefit may be that information on misalignment may become available, and may be used for monitoring or correction. The first sensor area may be mostly insensitive to spot alignment changes, while the second sensor area or areas may provide a signal that increases when the spot drifts towards the edge.

The spacing and size of the first and second sensor areas may be chosen to be similar to an average second mirror facet size. It may further be possible to account for different second mirror facet sizes and different clipping by adjusting the above mentioned calibration coefficients. As an alternative, a slightly larger sensor spacing may be used, and the spots could be offset on the sensors, which may provide that a clipping behavior may mimic an actual second mirror facet.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A dose control system configured to control a dose of a radiation beam comprising
an energy sensor comprising
- a first sensor area configured to measure an intensity of the radiation beam, and
- at least one second sensor area configured to measure an impact of misalignment or clipping of the radiation beam on the intensity of the radiation beam, and
a control device configured to
- determine a difference between the measured intensity of the radiation beam and the measured impact of misalignment or clipping of the radiation beam on the intensity of the radiation beam, and
- control a dose of the radiation beam on the basis of the determined difference.

2. The dose control system according to claim 1, wherein the at least one second sensor area is arranged around the first sensor area.

3. The dose control system according to claim 2, wherein the at least one second sensor area is circular around the first sensor area.

4. The dose control system according to any one of the preceding claims, wherein the energy sensor comprises at least two second sensor areas.

5. The dose control system according to any one of the preceding claims, wherein the at least one second sensor area is offset in respect of the first sensor area.

6. The dose control system according to claim 5, comprising at least two second sensor areas comprise a first pair of second sensor areas arranged to measure a deviation of the radiation beam in a first direction perpendicular to the radiation beam and a second pair of second sensor areas arranged to measure a deviation of the radiation beam in an second direction perpendicular to the radiation beam, the second direction being perpendicular to the first direction.

7. The dose control system according to any one of the preceding claims, wherein the control device is configured to, prior to determining the difference between the measured intensity of the radiation beam and the measured impact of misalignment or clipping of the radiation beam on the intensity of the radiation beam:
- multiply the measured intensity of the radiation beam by a first weight factor, and
- multiply the measured impact of misalignment or clipping of the radiation beam on the intensity of the radiation beam by a second weight factor.

8. The dose control system according to claim 7, wherein the control device is configured to calibrate the first weight factor and the second weight factor on the basis of a spatial energy distribution measurement of the radiation beam.

9. An illuminator configured to condition a radiation beam, the illuminator comprising the dose control system according to any one of the preceding claims.

10. The illuminator according to claim 9, comprising a first mirror comprising a plurality of facets, wherein a subset of the plurality of facets is configured to branch off a fraction of the radiation beam onto the energy sensor.

11. The illuminator according to claim 10, as far as dependent on claim 2 or 3, wherein the subset of the plurality of facets is configured to project a center of the branched off fraction of the radiation beam onto the first sensor area and an edge of the branched off fraction of the radiation beam onto the at least one second sensor area.

12. The illuminator according to claim 10, as far as dependent on claim 5, wherein the subset of the plurality of facets is configured to branch off the fraction of the radiation beam onto the first sensor area of the energy sensor and wherein a further subset of the plurality of facets is configured to branch off further fraction of the radiation beam onto the second sensor area.

13. The illuminator according to any one of claims 10 - 12 further comprising a second mirror, wherein the first mirror is configured to project the radiation beam onto the second mirror and wherein the subset of the plurality of facets is configured to branch of the fraction of the radiation beam before the second mirror.

14. A lithographic apparatus comprising the dose control system according to any one of claims 1 to 8 or the illuminator according to any one of claims 9 - 13.

15. A method of controlling a dose of a radiation beam comprising
- measuring an intensity of the radiation beam, and
- measuring an impact of misalignment or clipping of the radiation beam on the intensity of the radiation beam,
- determining a difference between the measured intensity of the radiation beam and the measured impact of misalignment or clipping of the radiation beam on the intensity of the radiation beam, and
- controlling a dose of the radiation beam on the basis of the determined difference.

16. A method of generating radiation comprising
generating a plasma,
exciting the plasma to emit radiation, and
controlling a dose of the radiation by the method of controlling a dose according to claim 15.

17. A method of manufacturing a semiconductor device comprising the steps of receiving a substrate with a photoresist layer
directing radiation generated by the method of claim 16 to transfer a pattern from a patterning device onto the photoresist layer; and
removing a portion of the photoresist layer to form the pattern over the substrate.

18. A device manufactured according to the method of claim 17.
